# DEMANDE DE BREVET EUROPEEN

(11) **EP 3 156 854 A1**
(43) Date de publication de la demande: **19.04.2017**
(21) Numéro de dépôt: 15189552.1
(22) Date de dépôt: 13.10.2015
(51) Int. Cl.: G04G 21/04

(54) **MONTRE-BRACELET MECANIQUE A LAQUELLE EST ASSOCIEE UNE FONCTION ELECTRONIQUE**

(71) Demandeur: The Swatch Group Research and Development Ltd., 2074 Marin (CH)
(72) Inventeur: MARTIN, Jean-Claude, 2037 Montmollin (CH); BORN, Jean-Jacques, 1110 Morges (CH); CONUS, Thierry, 2543 Lengnau (CH); EGGEN, Jean-Claude, 2552 Orpund (CH); FLEURY, Emmanuel, 2740 Moutier (CH); WILLEMIN, Michel, 2515 Prêles (CH)
(74) Mandataire: Supper, Marc

(57) **Abrégé**

Montre-bracelet comprenant un dispositif mécanique (20) d'exécution d'une première fonction mécanique agencé pour émettre un premier signal d'alarme acoustique, et un dispositif électronique (56) logé dans un bracelet (4) et agencé pour produire un second signal d'alarme acoustique et/ou une vibration mécanique, le dispositif électronique (56) étant agencé pour produire le second signal d'alarme acoustique au moment où le dispositif mécanique (20) d'exécution de la première fonction mécanique produit le premier signal d'alarme acoustique.

## Description

### Domaine technique de l'invention

La présente invention concerne une boîte de montre renfermant un mouvement d'horlogerie mécanique et un bracelet de montre associé à la boîte de montre de manière amovible, le bracelet de montre renfermant un dispositif électronique permettant de réaliser une fonction électronique qui vient compléter ou améliorer la ou les fonction(s) mécanique(s) réalisée(s) par le mouvement d'horlogerie mécanique logé dans la boîte de montre.

### Arrière-plan technologique de l'invention

On connaît l'attachement qu'éprouvent les utilisateurs à l'égard de leurs montres mécaniques. En effet, les mouvements d'horlogerie mécaniques sont synonymes d'un haut niveau de savoir-faire notamment en termes de miniaturisation, de précision dans l'exécution des composants, de décoration, de fiabilité de fonctionnement dans des conditions parfois extrêmes et de choix des complications horlogères proposées, valeurs que l'on retrouve moins dans le domaine des montres électroniques. Cependant, il est des fonctions, par exemple l'éclairage, offertes par les montres électroniques qui ne sont pas disponibles dans des montres purement mécaniques. C'est pourquoi une tendance actuelle forte vise à associer aux montres purement mécaniques une ou plusieurs fonction(s) électronique(s) additionnelle(s), sans néanmoins devoir aucunement modifier le mouvement d'horlogerie mécanique.

Pour atteindre cet objectif, il a déjà été proposé d'intégrer dans le bracelet des montres mécaniques des dispositifs électroniques permettant d'exécuter des fonctions électroniques additionnelles qui vont s'ajouter aux fonctions réalisées par le mouvement d'horlogerie mécanique de la montre-bracelet. A titre d'exemple, on peut citer le bracelet E-strap® commercialisé par la société Montblanc. De la sorte, l'utilisateur conserve inchangée sa montre mécanique et la valeur émotionnelle qui se rattache à une telle montre, tout en pouvant bénéficier de fonctions supplémentaires que seuls des dispositifs électroniques peuvent offrir.

On comprend de ce qui précède que le but des bracelets de montre du type décrit ci-dessus dans lesquels sont intégrés des dispositifs électroniques est d'offrir au moins une fonction électronique supplémentaire qui vient s'ajouter aux fonctions réalisées par le mouvement d'horlogerie mécanique de la montre. Autrement dit, l'exécution par le mouvement d'horlogerie mécanique renfermé dans la boîte de montre d'une fonction mécanique est totalement indépendante de l'exécution par le dispositif électronique logé dans l'épaisseur du bracelet ou dans la boucle de fermeture du bracelet d'une fonction électronique et réciproquement, si bien qu'il est tout à fait envisageable d'associer un bracelet donné à des boîtes de montres pouvant être de marques différentes.

Par contre, à la connaissance de la Demanderesse, il semble qu'il n'existe actuellement pas sur le marché de bracelet de montre dans lequel est intégré un dispositif électronique dont l'exécution de la fonction pour laquelle il est prévu va dépendre de l'exécution correspondante d'une fonction assurée par le mouvement d'horlogerie mécanique.

### Résumé de l'invention

La présente invention a pour but d'associer à une montre-bracelet mécanique agencée pour exécuter au moins une première fonction mécanique un dispositif électronique agencé pour exécuter au moins une seconde fonction électronique, l'exécution par le dispositif électronique de la seconde fonction électronique étant conditionnée par l'exécution par le mouvement d'horlogerie de la première fonction mécanique.

A cet effet, la présente invention concerne une montre-bracelet comprenant une boîte de montre dans laquelle est logé un mouvement d'horlogerie mécanique comprenant un dispositif mécanique d'exécution d'au moins une première fonction mécanique, la boîte de montre étant associée à un bracelet de montre dans lequel est logé un dispositif électronique agencé pour exécuter au moins une seconde fonction électronique, l'exécution de la seconde fonction électronique étant conditionnée par l'exécution de la première fonction mécanique.

Selon un mode préféré de réalisation de l'invention, le dispositif mécanique d'exécution de la première fonction mécanique est agencé pour produire un premier signal d'alarme acoustique, et le dispositif électronique logé dans le bracelet est agencé pour produire un second signal d'alarme acoustique et/ou une vibration mécanique, le dispositif électronique étant agencé pour produire le second signal d'alarme acoustique au moment où le dispositif mécanique d'exécution de la première fonction mécanique produit le premier signal d'alarme acoustique. Il est aussi envisageable de différer dans le temps, par une durée fixe ou pouvant être sélectionnée par l'utilisateur, l'activation du second signal d'alarme acoustique.

Grâce à ces caractéristiques, la présente invention procure une montre-bracelet mécanique comprenant un mouvement d'horlogerie mécanique doté d'un dispositif mécanique agencé pour exécuter une fonction mécanique et auquel est associé un dispositif électronique logé dans l'épaisseur du bracelet et agencé pour exécuter une fonction électronique au moment précis où le dispositif mécanique du mouvement d'horlogerie mécanique exécute la fonction mécanique. On comprend donc que, dans un tel agencement, le mouvement d'horlogerie mécanique joue le rôle d'un maître et le dispositif électronique logé dans le bracelet joue le rôle de l'esclave.

Par montre-bracelet mécanique on entend une montre-bracelet dont les fonctions horlogères et, le cas échéant, les fonctions non liées au temps sont assurées uniquement par des composants mécaniques auxquels l'énergie nécessaire à leur fonctionnement est fournie par un ou plusieurs ressorts de barillet.

Par dispositif électronique, on entend un dispositif dont les fonctions sont assurées uniquement par des composants électriques ou électroniques et auxquels l'énergie nécessaire à leur fonctionnement est fournie par une pile ou un accumulateur éventuellement rechargeable.

Dans le mode préféré de réalisation de l'invention, le dispositif mécanique d'exécution de la première fonction mécanique est un dispositif mécanique de sonnerie agencé pour produire un premier signal d'alarme acoustique, et le dispositif électronique logé dans le bracelet est agencé pour produire un second signal d'alarme acoustique et/ou une vibration mécanique. Ainsi, lorsque le dispositif mécanique de sonnerie émet son signal d'alarme acoustique, le dispositif électronique émet simultanément ou en différé son propre signal d'alarme acoustique et/ou mécanique. Le dispositif électronique logé dans le bracelet permet donc d'améliorer les performances de fonctionnement du dispositif mécanique de sonnerie, notamment en termes de puissance acoustique produite et de mélodie par sélection et combinaison de fréquences. Ceci est très avantageux car, actuellement, le niveau sonore produit par un mouvement d'horlogerie équipé d'un dispositif mécanique de sonnerie est faible, typiquement compris entre 65 et 75 dB à 40 cm de distance. Ceci est notamment dû aux contraintes dimensionnelles et de propagation du son imposées par la géométrie et le matériau dans lequel est réalisée la boîte de montre, ainsi qu'au peu d'énergie mécanique disponible, même dans le cas où le dispositif de sonnerie mécanique est alimenté par un barillet à ressort qui lui est propre. De plus, la durée du signal d'alarme acoustique n'excède habituellement pas 10 à 20 secondes, et l'on note une baisse de l'intensité du signal acoustique lorsque le ressort de barillet est presque complètement détendu.

Dans le cas où la boîte de montre comprend un fond transparent, le dispositif électronique d'exécution de la seconde fonction électronique comprend un capteur d'images, typiquement du type CMOS, agencé dans le bracelet de façon à se trouver sous le fond transparent. Dans ce cas, il peut être également prévu d'agencer une source de lumière dans le bracelet afin d'améliorer les conditions dans lesquelles le capteur d'images effectue les prises de vues.

Le capteur d'images est agencé pour scruter, à intervalles de temps réguliers et rapprochés, l'indication fournie par le dispositif mécanique de sonnerie. Dès que le capteur d'images constate que le dispositif mécanique de sonnerie se met en marche et émet le premier signal d'alarme acoustique, il envoie un signal électrique à une unité électronique de commande qui commande la mise en marche d'un générateur électronique de son. Ainsi, le signal d'alarme acoustique produit par le dispositif mécanique de sonnerie est renforcé par le signal d'alarme électronique, ce qui permet d'augmenter la puissance acoustique et donc d'améliorer l'audibilité du signal d'alarme acoustique produit par la montre-bracelet mécanique selon l'invention. Cela peut aussi permettre d'enrichir la sonorité de l'alarme acoustique produite par le dispositif mécanique en créant un son polyphonique. Afin que le capteur d'images puisse détecter le moment où le dispositif mécanique de sonnerie se met en marche et produit le premier signal d'alarme acoustique, il est prévu que le capteur d'images scrute à intervalles de temps réguliers et rapprochés un composant du dispositif mécanique de sonnerie qui, en temps normal, est immobile et qui se met en mouvement uniquement au moment où le dispositif mécanique de sonnerie émet le premier signal acoustique. Ce composant peut être, par exemple, une ancre de sonnerie qui pivote dans un plan horizontal autour de son point d'articulation.

Dans le cas où la boîte de montre comprend un fond opaque non conducteur de l'électricité, le dispositif électronique de détection de l'indication fournie par le dispositif mécanique de sonnerie comprend un capteur capacitif, magnétique ou inductif (merci de préciser le type des capteurs : structure, mode de fonctionnement, fabricants, références commerciales).

Dans le cas du capteur capacitif, celui-ci comprend typiquement un oscillateur RC, un démodulateur et un étage de sortie. Le fonctionnement d'un tel capteur capacitif se fait sans contact physique avec le dispositif mécanique de sonnerie et repose sur la modification du champ électrique dans sa zone active. Le capteur capacitif, disposé sous le fond de la boîte de montre, détecte une certaine valeur de capacité qui reste fixe aussi longtemps que le dispositif mécanique de sonnerie est au repos. Au moment où le dispositif mécanique de sonnerie se met en marche et émet le premier signal d'alarme acoustique, le capteur capacitif détecte une modification de la capacité provoquée par la mise en marche du dispositif mécanique de sonnerie, ce qui entraîne une variation de la fréquence d'oscillation du circuit RC. La détection de cette variation de fréquence génère un signal électrique de sortie qui est envoyé à l'unité électronique de commande qui commande la mise en marche du générateur électronique de son.

De manière similaire, le capteur magnétique observe une modification du champ magnétique provoquée par la mise en marche du dispositif mécanique de sonnerie. A titre d'exemple non limitatif, ce capteur magnétique peut être un capteur à magnétorésistance géante par exemple commercialisé par la société américaine NVE et également connu sous sa dénomination anglo-saxonne Giant Magnetoresistive Digital Switch ou GMR. La magnétorésistance est la propriété qu'ont certains matériaux de voir leur résistance électrique varier lorsqu'ils sont soumis à un champ magnétique. Ainsi, un capteur à magnétorésistance géante est agencé pour produire à sa sortie un signal électrique de commande en fonction de la variation du champ magnétique auquel il est soumis. Le capteur NVE est un capteur très basse consommation qui fonctionne à travers des fonds transparents (saphir, plexiglass, verre) ou des fonds opaques non-magnétiques (acier inoxydable, titane, aluminium, laiton, céramique, plastique). Il peut également s'agir d'un interrupteur Reed à lames souples. A cet effet, l'un au moins des composants du dispositif mécanique de sonnerie qui commence à se mouvoir lorsque le dispositif mécanique de sonnerie se met en marche est muni d'un aimant. Ainsi, lorsque le composant bouge, l'aimant se déplace concomitamment ce qui, dans le cas de l'interrupteur Reed, provoque une aimantation des contacts souples qui s'attirent mutuellement jusqu'à venir en contact l'un avec l'autre. L'interrupteur Reed est alors fermé et il peut envoyer un signal électrique de sortie à l'unité électronique de commande qui commande la mise en marche du générateur électronique de son.

Enfin, le capteur inductif comprend conventionnellement un bobinage réalisé autour d'un circuit magnétique qui a pour rôle de canaliser le champ magnétique. Au moins un composant du dispositif mécanique de sonnerie qui commence à se mouvoir lorsque le dispositif mécanique de sonnerie se met en marche est muni d'un aimant. Ainsi, lorsque le dispositif mécanique de sonnerie se met en marche, l'aimant bouge et induit un courant électrique dans le bobinage du capteur inductif. Le capteur inductif envoie un signal électrique de sortie à l'unité électronique de commande qui commande la mise en marche du générateur électronique de son.

Que le fond de la boîte de montre soit transparent ou opaque, conducteur ou non conducteur de l'électricité, le dispositif électronique de détection de l'indication fournie par le dispositif mécanique de sonnerie peut comprendre un dispositif simplifié comprenant un microphone qui détecte uniquement l'onde acoustique produite par la mise en marche du dispositif mécanique de sonnerie et envoie un signal électrique à l'unité électronique de commande qui commande la mise en marche du générateur électronique de son.

De même, quelles que soient les propriétés du fond de la boîte de montre, il peut être envisagé d'utiliser comme capteur un accéléromètre qui va mesurer l'activité du dispositif mécanique de sonnerie et détecter le moment où celui-ci se met en marche.

Selon une caractéristique complémentaire de l'invention, le dispositif mécanique d'exécution de la première fonction mécanique logé dans la boîte de montre comprend un organe indicateur mécanique qui fournit une indication sur l'état armé ou non-armé du dispositif mécanique d'exécution de la première fonction mécanique, et le dispositif électronique comprend des premiers moyens agencés pour scruter l'indication fournie par l'organe indicateur mécanique et des seconds moyens qui sont agencés pour scruter l'instant auquel la première fonction mécanique va se déclencher.

### Brève description des figures

D'autres caractéristiques et avantages de la présente invention ressortiront plus clairement de la description détaillée qui suit d'un exemple de réalisation d'une montre-bracelet mécanique selon l'invention à laquelle est associée une fonction électronique, cet exemple étant donné à titre purement illustratif et non limitatif seulement en liaison avec le dessin annexé sur lequel :
- la figure 1 est une vue de dessus d'une boîte de montre destinée à être équipée d'un bracelet selon l'invention ;
- la figure 2 est une vue en perspective de dessous de la boîte de montre de la figure 1 ;
- la figure 3 est une vue en perspective d'un exemple de réalisation du dispositif mécanique de sonnerie ;
- la figure 4a est une vue en perspective du bracelet dans lequel est logé le dispositif électronique agencé pour exécuter la seconde fonction électronique ;
- la figure 4b est une vue à plus grande échelle du dispositif électronique entouré d'un cercle sur la figure 4a ;
- les figures 5, 6 et 7 illustrent schématiquement l'ensemble formé par le dispositif mécanique agencé pour produire le premier signal d'alarme acoustique et le dispositif électronique agencé pour produire le second signal d'alarme acoustique selon que le dispositif mécanique de sonnerie est au repos, en fonctionnement, puis à nouveau à l'arrêt ;
- les figures 8 et 9 sont des vues en coupe respectivement selon les lignes VIII-VIII et IX-IX des figures 5 et 6 ;
- la figure 10 est une représentation schématique partielle de la boîte de montre selon l'invention dans le cas où le fond de la montre est opaque et non conducteur de l'électricité et où le dispositif électronique agencé pour exécuter la seconde fonction électronique comprend un capteur capacitif ;
- la figure 11 est une représentation schématique partielle de la boîte de montre selon l'invention dans le cas où le fond de la montre est opaque et non conducteur de l'électricité et où le dispositif électronique agencé pour exécuter la seconde fonction électronique comprend un capteur magnétique ;
- la figure 12 est une représentation schématique partielle de la boîte de montre selon l'invention dans le cas où le fond de la montre est opaque et non conducteur de l'électricité et où le dispositif électronique agencé pour exécuter la seconde fonction électronique comprend un capteur inductif ;
- la figure 13 est une représentation schématique partielle de la boîte de montre selon l'invention dans le cas où la boîte de montre comprend un

fond opaque conducteur de l'électricité et où le dispositif électronique de détection de l'indication fournie par le dispositif mécanique de sonnerie comprend un dispositif simplifié comprenant un microphone qui détecte l'onde acoustique produite par la mise en marche du dispositif mécanique de sonnerie et envoie un signal électrique à l'unité électronique de commande qui commande la mise en marche du générateur électronique de son ;

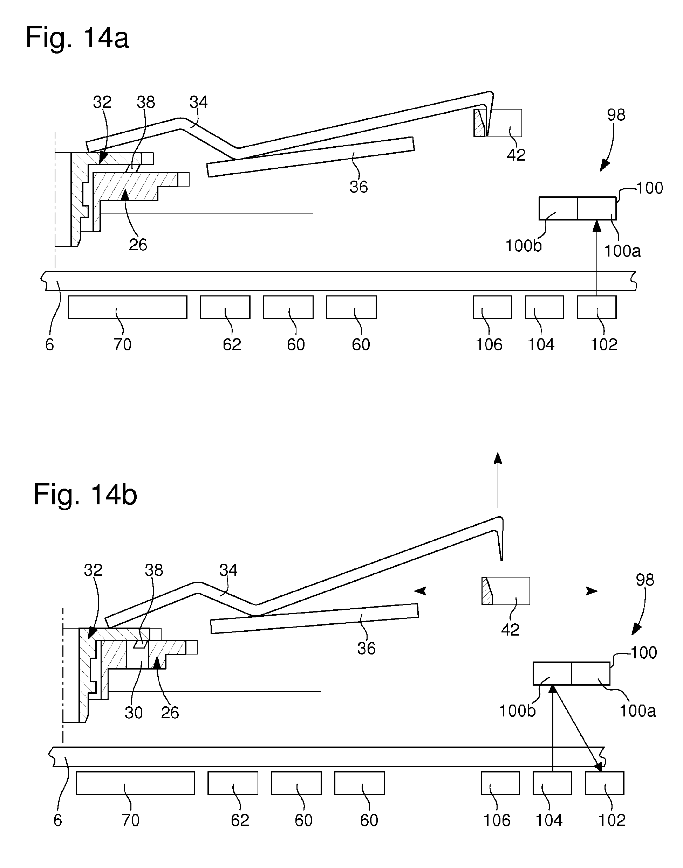

- la figure 14a est une représentation schématique partielle de la boîte de montre selon l'invention dans le cas où le dispositif mécanique de sonnerie comprend un organe indicateur mécanique qui indique l'état non-armé du dispositif mécanique de sonnerie et où le dispositif électronique comprend une source de lumière et un détecteur de lumière ;
- la figure 14b est une vue analogue à celle de la figure 14a dans le cas où l'organe indicateur mécanique indique l'état armé du dispositif mécanique de sonnerie et où la lumière émise par la source de lumière est réfléchie par la portion de surface réfléchissante de l'organe indicateur mécanique en direction du détecteur de lumière ;

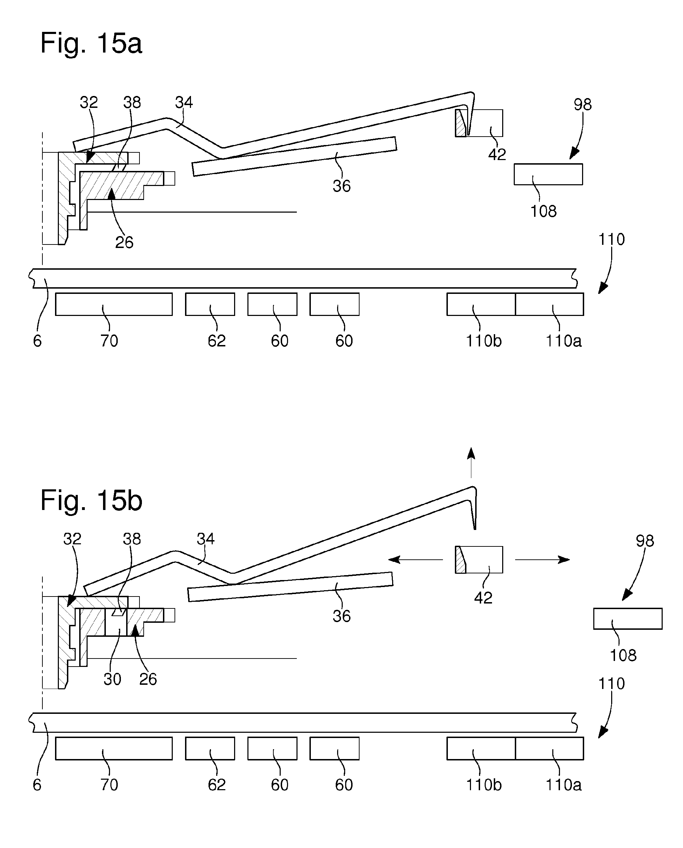

- la figure 15a est une représentation schématique partielle de la boîte de montre selon l'invention dans le cas où le dispositif mécanique de sonnerie comprend un organe indicateur mécanique qui indique l'état non-armé du dispositif mécanique de sonnerie et où le dispositif électronique comprend un capteur d'images dont une première fraction de la surface est utilisée pour scruter l'indication fournie par l'organe indicateur mécanique, et dont une seconde fraction de la surface est utilisée pour scruter la mise en marche du dispositif mécanique de sonnerie ;
- la figure 15b est une vue analogue à celle de la figure 15a dans le cas où l'organe indicateur mécanique s'efface et sort du champ de vision du capteur d'images lorsque le dispositif mécanique de sonnerie est armé par l'utilisateur ;

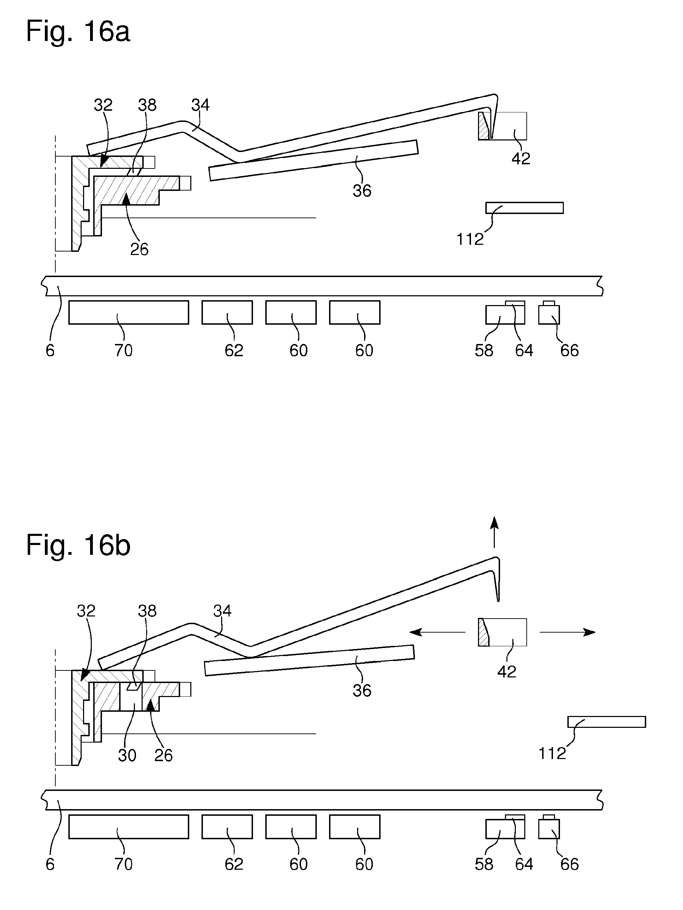

- la figure 16a est une représentation schématique partielle de la boîte de montre selon l'invention dans le cas où le dispositif mécanique de sonnerie comprend un organe indicateur mécanique qui masque le dispositif mécanique de sonnerie lorsque ce dernier n'est pas armé, et
- la figure 16b est une vue analogue à celle de la figure 16a dans le cas où l'organe indicateur mécanique s'est effacé.

### Description détaillée d'un mode de réalisation de l'invention

La présente invention procède de l'idée générale inventive qui consiste à associer à une montre-bracelet mécanique conçue pour exécuter une première fonction mécanique en plus de l'affichage de l'heure courante un bracelet dans l'épaisseur duquel est logé un dispositif électronique conçu pour exécuter une seconde fonction électronique, l'exécution de la seconde fonction électronique étant conditionnée par l'exécution de la première fonction mécanique. Dans un mode de réalisation préféré mais non limitatif de la présente invention, la montre-bracelet mécanique est agencée pour émettre une première alarme acoustique à un moment prédéterminé programmé par l'utilisateur, et le dispositif électronique logé dans le bracelet est agencé pour émettre une seconde alarme acoustique et/ou une vibration mécanique au moment où la montre émet la première alarme acoustique. Il est ainsi possible d'augmenter la puissance acoustique du signal d'alarme produit par la montre-bracelet selon l'invention sans devoir apporter aucune modification au mouvement mécanique logé dans la montre. Il est également possible d'augmenter la durée du signal d'alarme et d'émettre d'autres sons que ceux produits par le mouvement mécanique, en harmonie avec ces derniers.

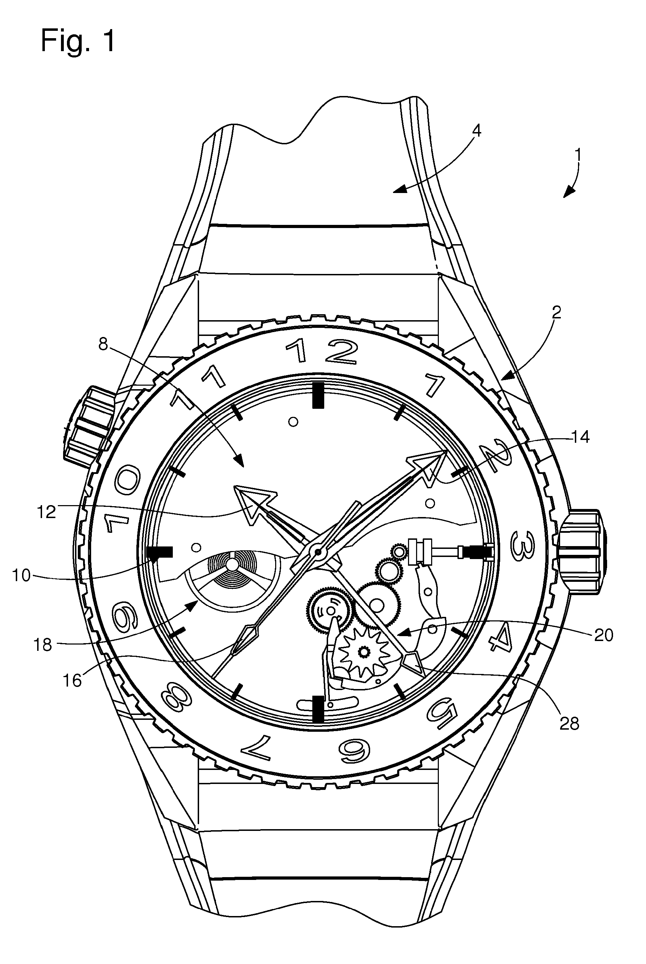

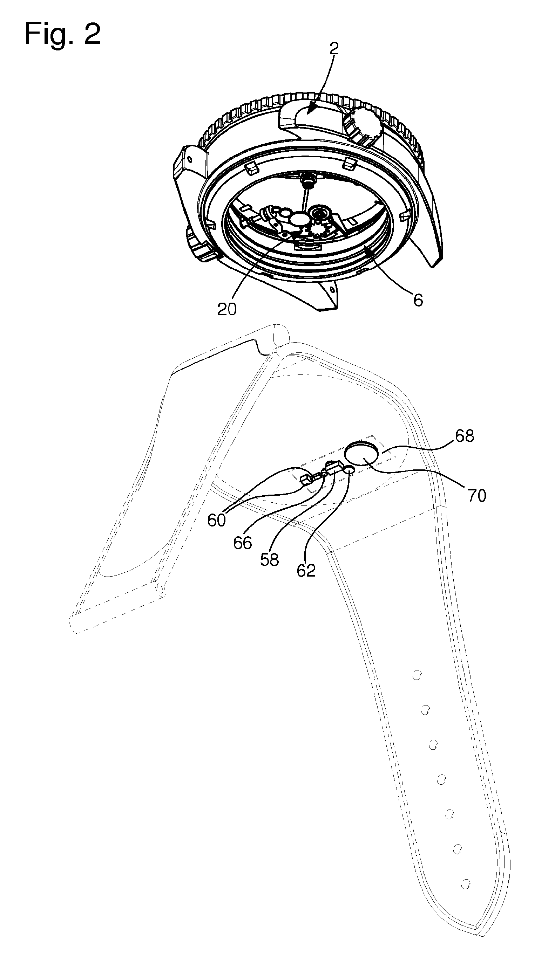

Désignée dans son ensemble par la référence numérique générale 1, la montre-bracelet selon l'invention comprend (voir figures 1 et 2) une boîte de montre 2 conçue pour être portée au poignet d'un utilisateur au moyen d'un bracelet 4. Dans le mode de réalisation préféré mais non limitatif de l'invention, la boîte de montre 2 est fermée à sa base par un fond 6 et à son sommet par une glace 8 qui recouvre un cadran 10 au-dessus duquel se déplacent des aiguilles d'heures 12, de minutes 14 et de secondes 16 pour l'affichage de l'heure courante. Dans l'exemple illustré à la figure 1, le cadran 10 est représenté en transparence. Il va néanmoins de soi que pour les besoins de la présente invention, le cadran 10 n'a nullement besoin d'être transparent et qu'il sera préférentiellement opaque.

Un mouvement d'horlogerie mécanique 18 conçu pour entraîner les aiguilles 12, 14 et 16 d'affichage de l'heure courante est logé dans la boîte de montre 2. Ce mouvement d'horlogerie mécanique 18 comprend en outre un dispositif mécanique 20 agencé pour produire au moins une première fonction mécanique, par exemple émettre un premier signal d'alarme acoustique.

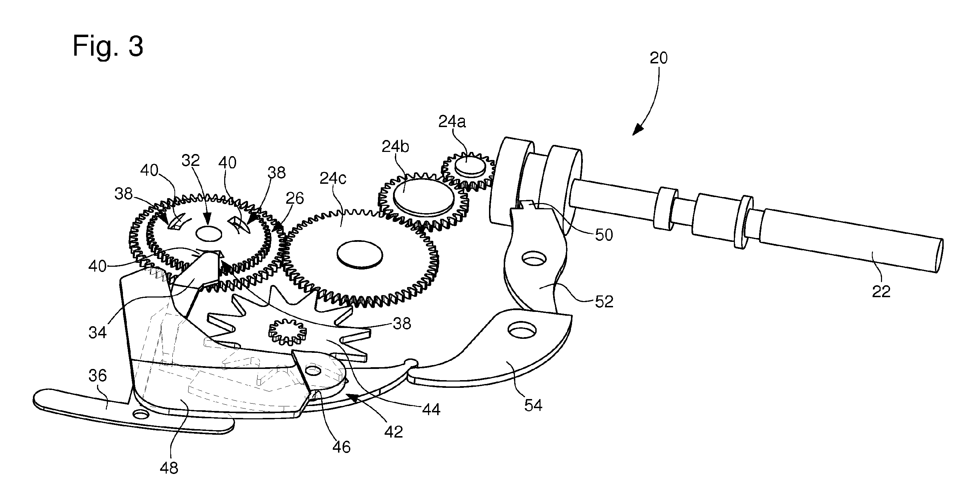

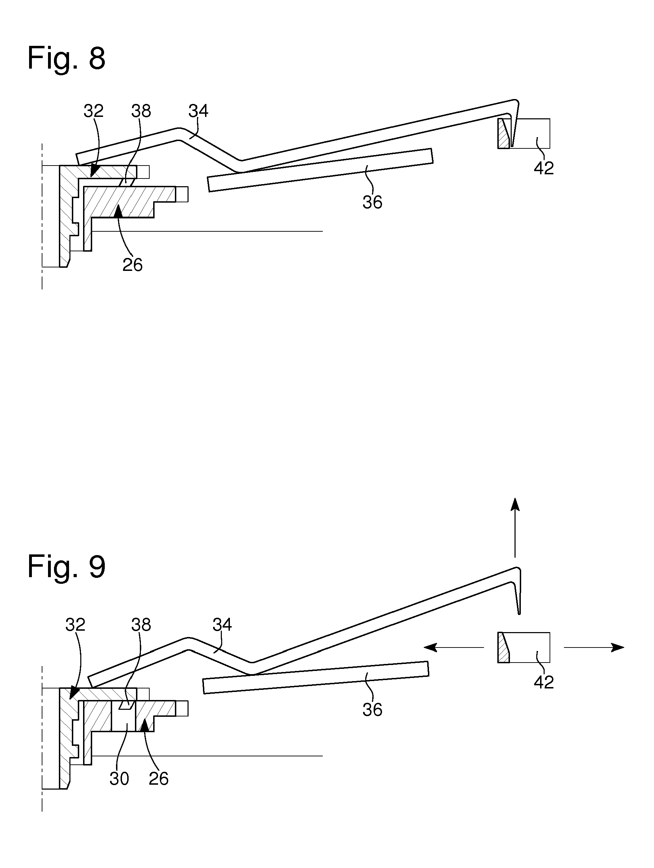

A titre d'exemple illustratif seulement (voir figure 3), le dispositif mécanique de sonnerie 20 comprend une tige de remontoir 22 qui fait tourner par l'intermédiaire d'une première, d'une deuxième et d'une troisième roue de renvoi 24a, 24b et 24c une roue de déclenchement 26. Le canon de la roue de déclenchement 26 porte un index 28 visible sur la figure 1 que l'on peut placer en regard de l'heure de sonnerie désirée. La planche de la roue de déclenchement 26 est percée de trois ouvertures 30 placées sur trois rayons différents (voir figure 9). Une roue des heures 32 pivote au-dessus de la roue de déclenchement 26 et est plaquée contre la roue de déclenchement 26 par un levier de déclenchement 34 armé par un ressort 36. La roue des heures 32 possède dans sa planche trois ergots 38 munis chacun d'un plan incliné 40. La roue des heures 32, entraînée par le mouvement, tourne et, à l'instant prévu pour la sonnerie, les trois ergots 38 se trouvent en face des ouvertures 30 et tombent dans ces dernières, de sorte que la roue des heures 32 vient se plaquer contre la roue de déclenchement 26. Sous l'effet de ce mouvement, le levier de déclenchement 34 bascule vers le haut et libère une ancre de sonnerie 42 qui, entraînée par une roue de sonnerie 44, se met à osciller dans un plan horizontal autour de son point de pivotement 46 (voir figure 9). La roue de sonnerie 44 qui est directement entraînée par un barillet de sonnerie (non représenté) agit à la façon d'une roue d'échappement qui entraîne l'ancre de sonnerie 42. L'ancre de sonnerie 42 porte un marteau 48 qui frappe une goupille fixée au fond de la boîte de façon à faire retentir la sonnerie. L'extrémité d'une bascule de remontoir de sonnerie 50 est en relation avec une bascule de verrou 52 qui agit sur un verrou de sonnerie 54. Le verrou de sonnerie 54 immobilise l'ancre de sonnerie 42 lorsque la tige de remontoir 22 est en position de mise à l'heure.

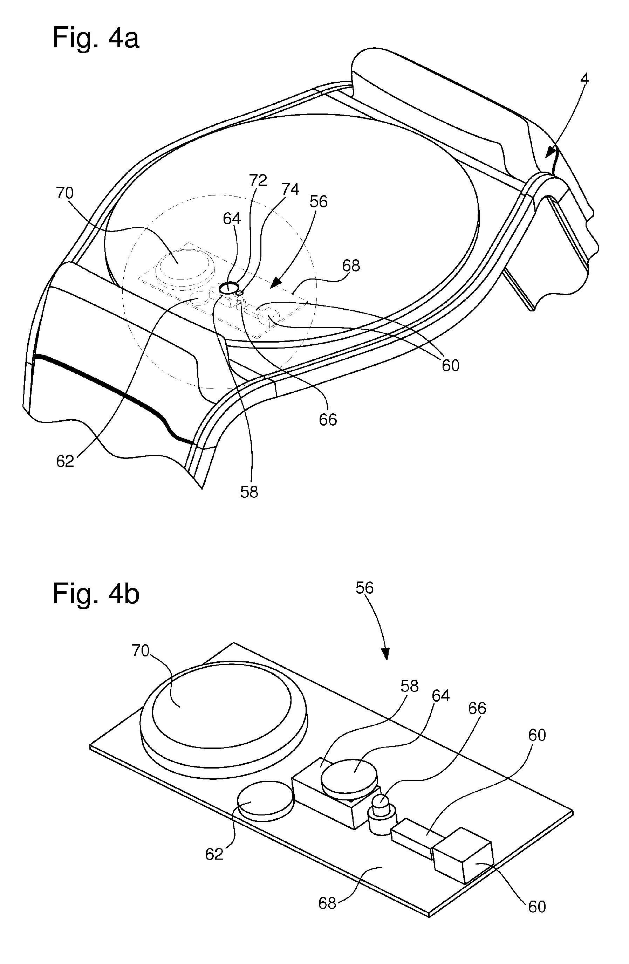

Comme représenté sur les figures 4a et 4b, un dispositif électronique 56 logé dans le bracelet 4 est agencé pour exécuter au moins une seconde fonction électronique, par exemple émettre un second signal d'alarme acoustique et/ou produire une vibration mécanique, l'exécution de la seconde fonction électronique étant conditionnée par l'exécution de la première fonction mécanique. Autrement dit, le dispositif électronique 56 va émettre le second signal d'alarme acoustique et/ou produire une vibration mécanique au moment où le dispositif mécanique de sonnerie 20 va produire le premier signal d'alarme acoustique. Le dispositif mécanique de sonnerie 20 logé dans la boîte de montre 2 est donc le maître du dispositif électronique 56 qui joue la fonction d'esclave. On notera que la fonction maître n'est pas dépendante de la fonction esclave et peut fonctionner normalement même si la fonction esclave n'est pas opérationnelle. On notera également que, selon une variante, il peut être envisagé de différer d'une durée fixe, par exemple 5 ou 10 secondes, ou choisie par l'utilisateur le moment où le dispositif électronique 56 va s'enclencher et produire le second signal acoustique.

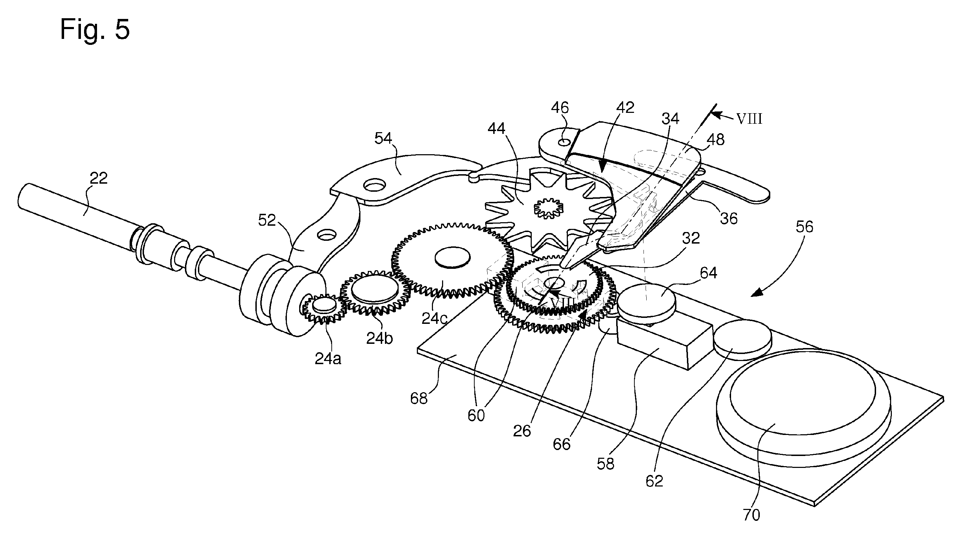

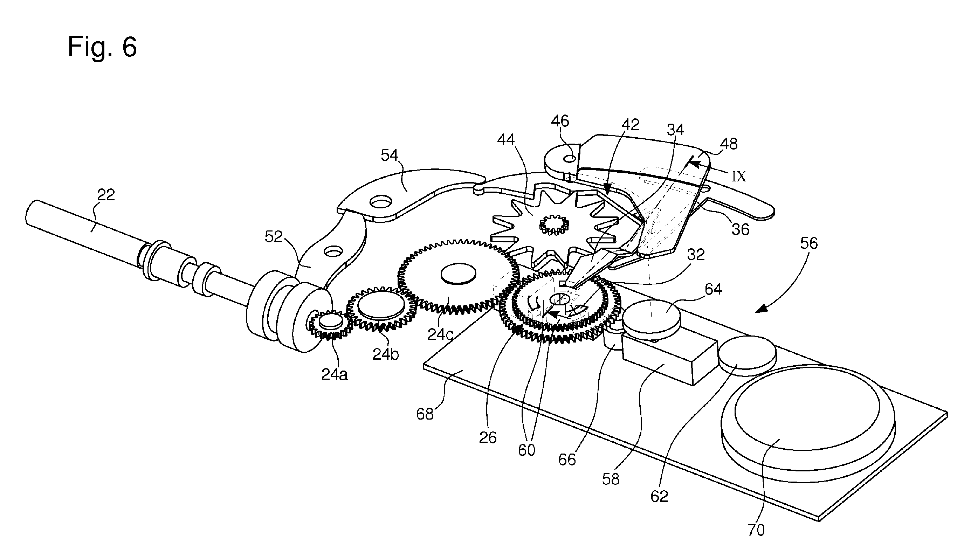

Le dispositif électronique 56 logé dans le bracelet 4 de la montre-bracelet 1 comprend quant à lui un capteur d'images 58 qui scrute à intervalles de temps réguliers et rapprochés le moment où le dispositif mécanique de sonnerie 20 va se mettre en marche. Le dispositif mécanique de sonnerie 20 est initialement à l'arrêt (figures 5 et 8). Au moment où le dispositif mécanique de sonnerie 20 se met en marche (figures 6 et 9), la roue des heures 32 se plaque contre la roue de déclenchement 26 et le levier de déclenchement 34, plaqué contre la roue des heures 32 par le ressort 36, pivote vers le haut, libérant l'ancre de sonnerie 42 qui se met à osciller dans le plan horizontal autour de son point de pivotement 46. Le marteau 48, porté par l'ancre de sonnerie 42, suit le mouvement de cette dernière et vient frapper par exemple une goupille. Le capteur d'images 58 détecte la mise en mouvement d'un mobile du dispositif mécanique de sonnerie tel que l'ancre de sonnerie 42 et envoie un signal électrique à une unité de commande 60 qui va commander la mise en marche d'un générateur électronique de son 62 de type électromécanique ou piézoélectrique. Avantageusement, le capteur d'images 58 est recouvert par une lentille de collimation 64 et une source de lumière 66 telle qu'une diode électroluminescente éclaire l'intérieur de la boîte de montre 2 à travers le fond 6 transparent. L'ensemble de ces composants électroniques est monté sur une feuille de circuit imprimé 68 logée dans l'épaisseur du bracelet 4 et est alimenté par une source de courant électrique 70. Bien-entendu, des ouvertures 72 et 74 sont ménagées au-dessus du capteur d'images 58 et de la source de lumière 66 dans la matière dont est réalisé le bracelet 4, ceci afin de permettre au capteur d'images 58 de scruter le dispositif mécanique de sonnerie 20 et à la source de lumière 66 d'éclairer la scène.

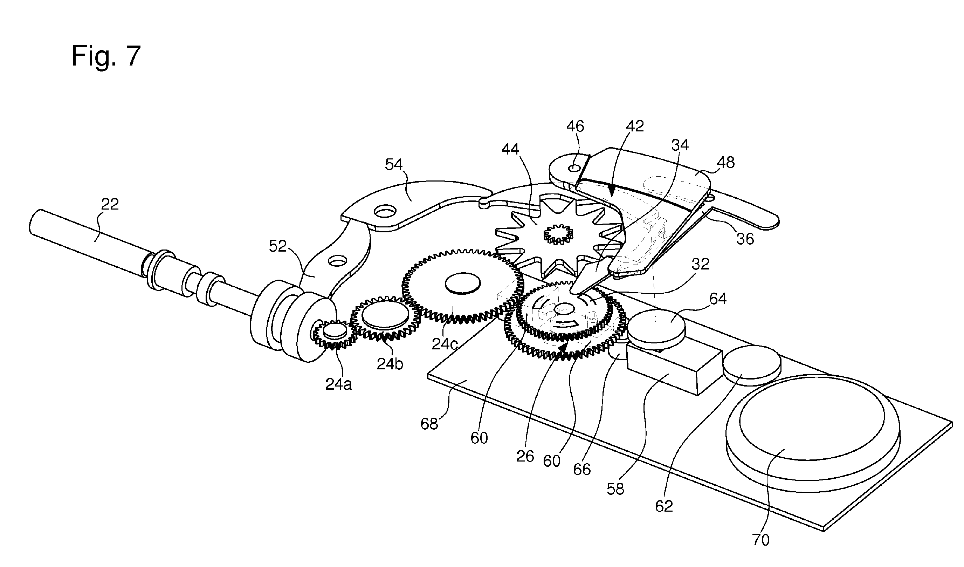

Le capteur d'images 58 est par exemple un capteur d'images commercialisé par la société STMicroelectronics sous la référence VD5376. Son épaisseur est comprise entre 180 µm et 725 µm, ses côtés mesurent respectivement 1900 µm et 1932 µm et sa surface active de 608x608 µm² est formée d'une matrice de 20x20 pixels. Un tel capteur d'images 58 est capable de détecter un changement dans les niveaux de gris d'une image qu'il scrute et donc de déceler par exemple le déplacement d'un objet tel que l'ancre de sonnerie 42. On comprendra que le capteur d'images 58 peut détecter la mise en mouvement d'un autre mobile comme la roue de sonnerie 44 ou bien le marteau 48. Un nouveau changement est observé par le capteur d'images 58 lorsque le premier signal d'alarme acoustique s'interrompt et que le mobile que scrute le capteur d'images 58 s'arrête (figure 7). L'image que voit le capteur d'images 58 devient en effet à nouveau immobile. Le capteur d'images 58 envoie alors un signal électrique à l'unité de commande 60 qui va commander l'arrêt du générateur électronique de son 62.

Selon une variante simplifiée d'exécution de l'invention, il peut être envisagé de fixer par avance la durée de la seconde alarme. Une fois démarrée suite à l'activation de la première alarme, la seconde alarme s'arrêtera de façon autonome une fois ce temps écoulé.

On remarque qu'un examen comparé des figures 5 et 6 permet de se rendre compte qu'à la figure 6, la roue des heures 32 s'est plaquée contre la roue de déclenchement 26 et qu'à la figure 7, la roue des heures 32 est à nouveau écartée de la roue de déclenchement 26.

Dans le cas où la boîte de montre 2 comprend un fond 6 opaque non conducteur de l'électricité, le dispositif électronique 56 de détection de l'indication fournie par le dispositif mécanique de sonnerie 20 comprend un capteur capacitif, magnétique ou inductif (merci de préciser le type des capteurs : structure, mode de fonctionnement, fabricants, références commerciales).

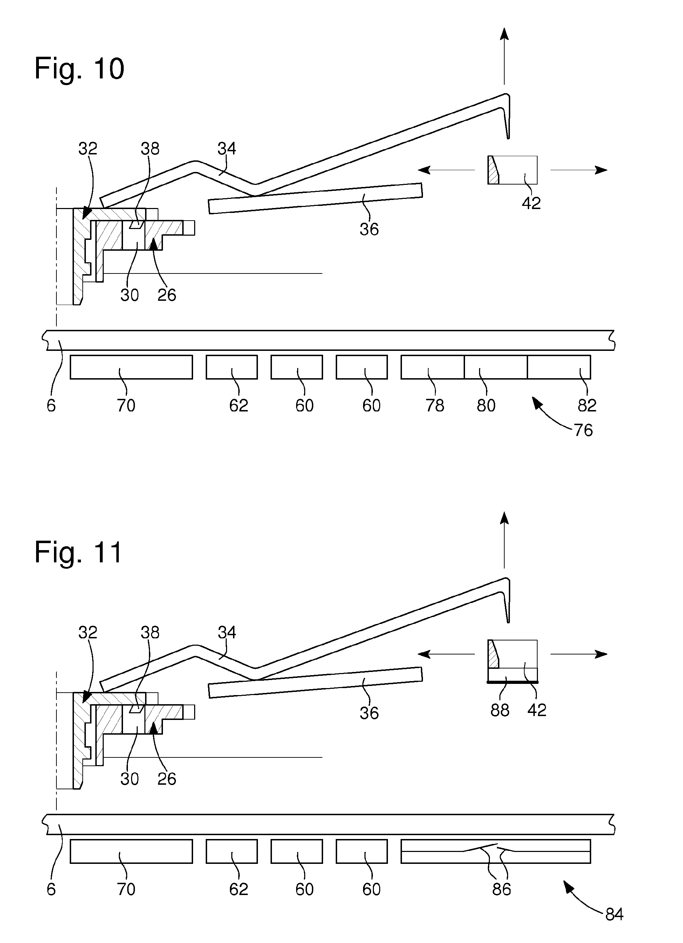

Dans le cas d'un capteur capacitif 76 (figure 10), celui-ci comprend typiquement un oscillateur RC 78, un démodulateur 80 et un étage de sortie 82. Le fonctionnement d'un tel capteur capacitif 76 se fait sans contact physique avec le dispositif mécanique de sonnerie 20 et repose sur la modification du champ électrique dans sa zone active. Le capteur capacitif 76, disposé sous le fond de la boîte de montre, détecte une certaine valeur de capacité qui reste fixe aussi longtemps que le dispositif mécanique de sonnerie 20 est au repos. Au moment où le dispositif mécanique de sonnerie 20 se met en marche et émet le premier signal d'alarme acoustique, le capteur capacitif 76 détecte une modification de la capacité provoquée par la mise en marche du dispositif mécanique de sonnerie 20, ce qui entraîne une modification de la fréquence d'oscillation du circuit RC 78. Suite à la détection de cette variation de fréquence, un signal électrique de sortie est généré et envoyé à l'unité électronique de commande 60 qui commande la mise en marche du générateur électronique de son 62. A titre d'exemple, le capteur capacitif peut être celui commercialisé par la société suisse EM-Microelectronic sous la référence EM6420. Il s'agit d'un capteur capacitif très basse consommation apte à fonctionner aussi bien avec des fonds transparents (saphir, plexiglass, verre) qu'avec des fonds opaques non métalliques (plastique, céramique). Il faut raccorder au circuit EM6420 une électrode qui sera placée dans le bracelet en face de la pièce en métal qui se mettra en mouvement lors de l'enclenchement de l'alarme.

De manière similaire (figure 11), le capteur magnétique tel qu'un capteur GMR commercialisé par la société NVE ou bien un interrupteur Reed 84 à lames souples 86 observe une modification du champ magnétique provoquée par la mise en marche du dispositif mécanique de sonnerie 20. A cet effet, l'un au moins des composants du dispositif mécanique de sonnerie 20, par exemple l'ancre de sonnerie 42, qui commence à se mouvoir lorsque le dispositif mécanique de sonnerie 20 se met en marche est muni d'un aimant 88. Ainsi, lorsque le composant bouge, l'aimant 88 se déplace concomitamment, ce qui provoque une aimantation des contacts souples 86 qui s'attirent mutuellement jusqu'à venir en contact l'un avec l'autre. L'interrupteur Reed 84 est alors fermé et il peut envoyer un signal électrique de sortie à l'unité électronique de commande 60 qui commande la mise en marche du générateur électronique de son 62.

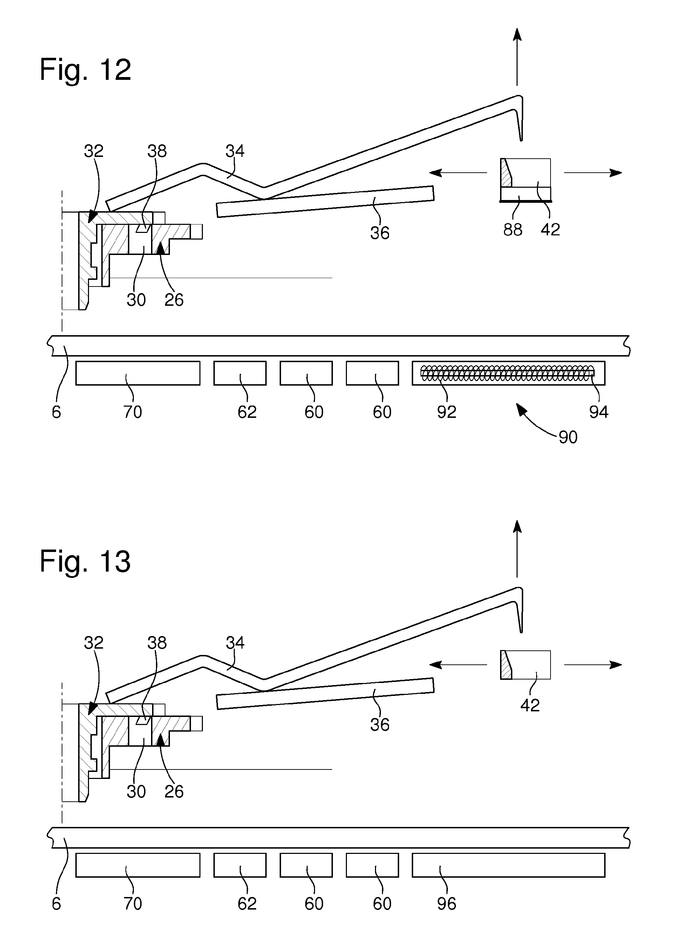

Enfin (figure 12), le capteur inductif 90 comprend conventionnellement un bobinage 92 réalisé autour d'un circuit magnétique 94 qui a pour rôle de canaliser le champ magnétique. Au moins un composant du dispositif mécanique de sonnerie 20, par exemple l'ancre de sonnerie 42, qui commence à se mouvoir lorsque le dispositif mécanique de sonnerie 20 se met en marche est muni d'un aimant 88. Ainsi, lorsque le dispositif mécanique de sonnerie 20 se met en marche, l'aimant 88 bouge et induit un courant électrique dans le bobinage 92 du capteur inductif 90. Le capteur inductif 90 envoie un signal électrique de sortie à l'unité électronique de commande 60 qui commande la mise en marche du générateur électronique de son 62.

A titre de variante, le capteur inductif peut comprendre un circuit oscillant LC dont l'inductance va varier sous l'effet du déplacement d'un composant métallique du dispositif mécanique.

Que le fond 6 de la boîte de montre 2 soit transparent ou opaque, conducteur ou non conducteur de l'électricité (figure 13), le dispositif électronique 56 de détection de l'indication fournie par le dispositif mécanique de sonnerie 20 peut comprendre un dispositif simplifié comprenant un microphone 96 qui détecte uniquement l'onde acoustique produite par la mise en marche du dispositif mécanique de sonnerie 20 et envoie un signal électrique à l'unité électronique de commande 60 qui commande la mise en marche du générateur électronique de son 62.

De même, quelles que soient les propriétés du fond 6 de la boîte de montre 2, il peut être envisagé d'utiliser comme capteur un accéléromètre qui va mesurer l'activité du dispositif mécanique de sonnerie et détecter les vibrations engendrées par le marteau 48 au moment où le dispositif mécanique de sonnerie se met en marche. Un accéléromètre bien adapté aux besoins de la présente invention est celui diffusé sous la référence ADXL362. Il s'agit d'un circuit très basse consommation qui constitue une alternative intéressante au microphone notamment du point de vue de l'étanchéité et des coûts d'intégration.

Comme vu en détail ci-dessus, le dispositif électronique 56 logé dans le bracelet 4 est agencé pour exécuter au moins une seconde fonction électronique, par exemple émettre un second signal d'alarme acoustique et/ou produire une vibration mécanique, l'exécution de la seconde fonction électronique étant conditionnée par l'exécution de la première fonction mécanique. Autrement dit, le dispositif électronique 56 va émettre le second signal d'alarme acoustique et/ou produire une vibration mécanique au moment où le dispositif mécanique de sonnerie 20 va produire le premier signal d'alarme acoustique. Le mouvement d'horlogerie mécanique 18 logé dans la boîte de montre 2 est donc le maître du dispositif électronique 56 qui joue la fonction d'esclave.

Selon une caractéristique complémentaire de l'invention, le dispositif mécanique 20 d'exécution de la première fonction mécanique logé dans la boîte de montre 2 comprend en outre un organe indicateur mécanique 98 qui fournit une indication sur l'état armé ou non-armé du dispositif mécanique 20 d'exécution de la première fonction mécanique. Ainsi, si le dispositif mécanique 20 est armé par l'utilisateur pour produire un signal d'alarme acoustique à une heure prédéterminée choisie par l'utilisateur, l'organe indicateur mécanique 98 va indiquer que le dispositif mécanique 20 est armé.

Selon un premier mode de réalisation illustré à la figure 14a, l'organe indicateur mécanique 98 comprend une pastille 100 dont une première partie de la surface 100a est absorbante et dont une seconde partie de la surface 100b est réfléchissante. Cette pastille 100 est agencée pour se déplacer entre une première et une seconde position selon que le dispositif mécanique 20 est armé ou non-armé. Quant au dispositif électronique 56, il comprend une source de lumière 102 telle qu'une diode électroluminescente et un capteur de lumière 104 tel qu'une photodiode logés dans le bracelet 4, sous la pastille 100. La lumière émise par la source de lumière 102 sera donc absorbée ou réfléchie selon qu'elle tombe sur la portion de surface 100a absorbante ou sur la portion de surface 100b réfléchissante de la pastille 100. Enfin, un capteur d'images 106 qui peut être du même type que celui décrit ci-avant ou plus simple scrute le moment où le dispositif mécanique de sonnerie 20 va se mettre en marche.

Le fonctionnement de ce dispositif est le suivant. La source de lumière 102 va, à intervalles de temps réguliers, envoyer un faisceau de lumière sur la pastille 100. Si le dispositif électronique 56 constate, en raison de l'absence de signal fourni par le capteur de lumière 104, que la lumière émise par la source de lumière 102 tombe sur la portion de surface 100a absorbante de la pastille 100 et est donc absorbée, il en conclut que le dispositif mécanique de sonnerie 20 n'est pas armé. Par conséquent, il n'est pas nécessaire que le capteur d'images 106 scrute le moment où le dispositif mécanique de sonnerie 20 va se mettre en marche, ce qui permet de réaliser des économies d'énergie. En effet, la source de lumière 102 éclaire la pastille 100 moins souvent que le capteur d'images 106 ne scrute le moment où le dispositif mécanique de sonnerie 20 va se mettre en marche. Lorsque l'utilisateur arme le dispositif mécanique de sonnerie 20 par exemple par pression sur un bouton-poussoir, la pastille 100 va se déplacer de façon que la lumière émise par la source de lumière 102 tombe sur la portion de surface 100b réfléchissante de la pastille 100. Ainsi, le dispositif électronique 56 va constater, en raison du signal fourni par le capteur de lumière 104, que la lumière émise par la source de lumière 102 tombe sur la portion de surface 100b réfléchissante de la pastille 100 et est donc réfléchie, et va conclure que le dispositif mécanique de sonnerie 20 est armé. A ce moment-là, le dispositif électronique 56 coupe l'alimentation électrique de la source de lumière 102 et commande la mise en marche du capteur d'images 106. Le capteur d'images 106 va alors scruter à intervalles de temps réguliers et rapprochés le moment où le dispositif mécanique de sonnerie 20 va se mettre en marche. Lorsque le dispositif mécanique de sonnerie 20 se met en marche, le fonctionnement du dispositif mécanique de sonnerie 20 et du dispositif électronique 56 est le même que celui décrit ci-dessus en liaison avec le premier mode de réalisation de l'invention.

Selon un second mode de réalisation non représenté, on peut envisager qu'au lieu d'avoir une portion de surface réfléchissante et une portion de surface absorbante, la pastille 100 soit munie d'une portion de surface qui réfléchit la lumière en direction du capteur de lumière 104 et une portion de surface qui réfléchit la lumière selon une direction dans laquelle le capteur de lumière 104 ne peut capter la lumière.

Selon un troisième mode de réalisation (voir figure 15a), le dispositif mécanique de sonnerie comprend l'organe indicateur mécanique 98 du type d'une pastille 108 qui indique l'état armé ou non-armé du dispositif mécanique de sonnerie, et le dispositif électronique 56 comprend un capteur d'images 110 du type déjà décrit dont une première fraction de la surface 110a est utilisée pour scruter l'indication fournie par l'organe indicateur mécanique 98, et dont une seconde fraction de la surface 110b est utilisée pour scruter la mise en marche du dispositif mécanique de sonnerie 20. On peut par exemple imaginer que la pastille 108 soit visible par la première fraction de surface 110a du capteur d'images 110 lorsque le dispositif mécanique de sonnerie 20 est à l'état non-armé, puis que la pastille 108 s'efface et sorte du champ de vision du capteur d'images 110 lorsque le dispositif mécanique de sonnerie 20 est armé par l'utilisateur (figure 15b). A ce moment-là, le dispositif électronique 56 note un changement dans le signal produit par le capteur d'images 110 et va donner l'ordre au capteur d'images 110 de scruter le dispositif mécanique de sonnerie 20 au moyen de la fraction de surface 110b.

Enfin, selon un dernier mode de réalisation (figure 16a), le dispositif mécanique de sonnerie comprend un organe indicateur mécanique 112 qui masque à la vue du capteur d'images 58 le dispositif mécanique de sonnerie 20 lorsque ce dernier n'est pas armé. Lorsque l'utilisateur arme le mécanisme de sonnerie 20 (figure 16b), l'organe indicateur mécanique 112 s'efface et l'unité de commande 60 observe un changement dans le signal fourni par le capteur d'images 58. En réponse à ce changement, l'unité de commande 60 commande au capteur d'images 58 de scruter le dispositif mécanique de sonnerie 20 afin de détecter la mise en marche de ce dernier.

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées. On notera en particulier qu'il est envisageable de différer dans le temps, par une durée fixe ou pouvant être sélectionnée par l'utilisateur, l'activation du second signal d'alarme acoustique. Autrement dit, la production du second signal acoustique généré par le dispositif électronique sera décalée temporellement par rapport à l'émission du premier signal acoustique produit par le dispositif mécanique. On comprendra également que le dispositif électronique peut indifféremment commander l'émission d'un second signal d'alarme acoustique ou d'une vibration mécanique grâce à l'utilisation d'un mécanisme vibrant logé dans l'épaisseur du bracelet. Au moment où le dispositif mécanique commence à produire le premier signal d'alarme acoustique, le dispositif électronique va commander la mise en marche du mécanisme vibrant qui va générer des vibrations qui vont être ressenties par l'utilisateur dans son poignet. Le mécanisme vibrant est typiquement un mécanisme à excentrique qui actionne une masselotte. De même, on notera que, selon une variante simplifiée d'exécution de l'invention, il peut être envisagé de fixer par avance la durée de la seconde alarme. Une fois démarrée suite à l'activation de la première alarme, la seconde alarme s'arrêtera de façon autonome une fois ce temps écoulé. Autrement dit, la seconde alarme s'activera au moment de la mise en marche de la première alarme et s'arrêtera au bout d'un temps prédéfini, indépendant de la durée d'activation de la première alarme. On notera aussi que, dans le cas où le capteur est un microphone ou un accéléromètre, il n'est pas indispensable qu'un tel capteur soit disposé sous le fond de la boîte de montre. Par conséquent, il est envisageable que le bracelet soit formé de deux brins séparés fixés chacun par une de leurs extrémités à la boîte de montre et dans lesquels sont intégrés les composants nécessaires à la mise en oeuvre de l'invention. On notera enfin que la présente invention couvre également un procédé de génération d'un signal d'alarme acoustique dans une montre-bracelet comprenant une boîte de montre 2 dans laquelle est logé un mouvement d'horlogerie mécanique 18 comprenant un dispositif mécanique 20 de sonnerie agencé pour produire un premier signal d'alarme acoustique, la boîte de montre 2 étant associée à un bracelet 4 dans lequel est logé un dispositif électronique 56 pour produire un second signal d'alarme acoustique et/ou une vibration mécanique, le dispositif électronique 56 étant agencé pour produire le second signal d'alarme acoustique au moment où le dispositif mécanique 20 d'exécution de la première fonction mécanique produit le premier signal d'alarme acoustique ou après une durée préétablie ou sélectionnable par l'utilisateur suivant la mise en marche du dispositif mécanique 20.

### Nomenclature

Montre-bracelet 1
Boîte de montre 2
Bracelet 4
Fond 6
Glace 8
Cadran 0
Aiguilles d'heures 12, de minutes 14 et de secondes 16
Mouvement d'horlogerie mécanique 8
Dispositif mécanique de sonnerie 20
Tige de remontoir 22
Première, seconde et troisième roue de renvoi 24a, 24b et 24c
Roue de déclenchement 26
Index 28
Trois ouvertures 80
Roue des heures 32
Levier de déclenchemen 34
Ressort 36
Trois ergots 38
Plan incliné 40
Ancre de sonnerie 42
Roue de sonnerie 44
Point de pivotement 46
Marteau 48
Bascule de remontoir de sonnerie 50
Bascule de verrou 52
Verrou de sonnerie 54
Dispositif électronique 56
Capteur d'images 58
Unité de commande 60
Générateur électronique de son 62
Lentille de collimation 64
Source de lumière 66
Feuille de circuit imprimé 68
Source de courant électrique 70
Ouvertures 72, 74
Capteur capacitif 76
Oscillateur RC 78
Démodulateur 80
Etage de sortie 82
Interrupteur reed 84
Lames souples 86
Aimant 88
Capteur inductif 90
Bobinage 92
Circuit magnétique 94
Microphone 96
Organe indicateur mécanique 98
Pastille 100
Première partie de surface 100a absorbante
Seconde partie de surface 100b réfléchissante
Source de lumière 102
Capteur de lumière 104
Capteur d'images 106
Pastille 108
Capteur d'images 110
Première fraction de surface 110a
Seconde fraction de surface 110b
Organe indicateur mécanique 112

## Revendications

1. Montre-bracelet comprenant une boîte de montre (2) dans laquelle est logé un mouvement d'horlogerie mécanique (18) comprenant un dispositif mécanique (20) d'exécution d'au moins une première fonction mécanique, la boîte de montre (2) étant associée à un bracelet (4) dans lequel est logé un dispositif électronique (56) agencé pour exécuter au moins une seconde fonction électronique, l'exécution de la seconde fonction électronique étant conditionnée par l'exécution de la première fonction mécanique.

2. Montre-bracelet selon la revendication 1, **caractérisée en ce que** le dispositif mécanique (20) d'exécution de la première fonction mécanique est un mécanisme de sonnerie agencé pour produire un premier signal d'alarme acoustique, et le dispositif électronique (56) logé dans le bracelet (4) est agencé pour produire un second signal d'alarme acoustique et/ou une vibration mécanique, le dispositif électronique (56) étant agencé pour produire le second signal d'alarme acoustique au moment où le dispositif mécanique (20) d'exécution de la première fonction mécanique produit le premier signal d'alarme acoustique ou après une durée préétablie ou sélectionnable par l'utilisateur suivant la mise en marche du dispositif mécanique (20).

3. Montre-bracelet selon la revendication 2 comprenant un fond (6) transparent, **caractérisée en ce que** le dispositif électronique (56) d'exécution de la seconde fonction électronique comprend un capteur d'images (58) agencé dans le bracelet (4) de façon à se trouver sous le fond (6) transparent et capable de détecter la mise en mouvement d'un mobile du dispositif mécanique (20).

4. Montre-bracelet selon la revendication 3, **caractérisée en ce que** le capteur d'images (58) est agencé de façon à être capable de détecter un changement dans les niveaux de gris d'une image qu'il scrute.

5. Montre-bracelet selon la revendication 4, **caractérisée en ce que** le capteur d'images (58) est du type CMOS.

6. Montre-bracelet selon l'une quelconque des revendications 3 à 5, **caractérisée en ce que** le dispositif électronique (56) d'exécution de la seconde fonction électronique comprend une source de lumière (66) agencée dans le bracelet (4) afin d'améliorer les conditions dans lesquelles le capteur d'images (58) effectue les prises de vues.

7. Montre-bracelet selon l'une quelconque des revendications 3 à 6, **caractérisée en ce que** le capteur d'images (58) est agencé pour envoyer un signal électrique à une unité électronique de commande (60) qui est agencée pour commander la mise en marche d'un générateur électronique de son (62) ou de vibrations dès que le capteur d'images (58) constate que le dispositif mécanique (20) d'exécution de la première fonction mécanique se met en marche et émet le premier signal d'alarme acoustique.

8. Montre-bracelet selon la revendication 6, **caractérisée en ce que** le capteur d'images (58) est agencé pour envoyer un signal électrique à l'unité de commande (60) qui est agencée pour commander l'arrêt du générateur électronique de son (62) ou de vibrations lorsque le mobile que scrute le capteur d'images (58) s'arrête et que le premier signal d'alarme acoustique s'interrompt.

9. Montre-bracelet selon l'une quelconque des revendications 3 à 8, **caractérisée en ce que** le capteur d'images (58) est recouvert par une lentille de collimation (64).

10. Montre-bracelet selon l'une quelconque des revendications 1 ou 2 comprenant un fond (6) opaque non conducteur de l'électricité, **caractérisée en ce que** le dispositif électronique (56) d'exécution de la seconde fonction électronique comprend un capteur capacitif (76), un capteur magnétique ou un capteur inductif (90) agencé dans le bracelet (4) de façon à se trouver sous le fond (6) opaque non conducteur de l'électricité et capable de détecter la mise en mouvement d'un mobile du dispositif mécanique (20).

11. Montre-bracelet selon la revendication 10, **caractérisée en ce que** le capteur capacitif (76) comprend un oscillateur RC (78), un démodulateur (80) et un étage de sortie (82) qui sont agencés pour envoyer un signal électrique à une unité électronique de commande (60) qui est agencée pour commander la mise en marche d'un générateur électronique de son (62) ou de vibrations dès que le capteur capacitif (76) détecte une modification de la capacité provoquée par la mise en marche du dispositif mécanique (20) d'exécution de la première fonction mécanique et l'émission du premier signal d'alarme acoustique.

12. Montre-bracelet selon la revendication 10, **caractérisée en ce que** le capteur magnétique est un interrupteur Reed (84) à lames souples (86) qui est agencé pour envoyer un signal électrique à une unité électronique de commande (60) qui est agencée pour commander la mise en marche d'un générateur électronique de son (62) ou de vibrations dès que les lames souples (86) s'attirent mutuellement et viennent en contact l'une avec l'autre sous l'effet du déplacement d'un aimant (88) qui commence à se mouvoir lorsque le dispositif mécanique (20) d'exécution de la première fonction mécanique se met en marche.

13. Montre-bracelet selon la revendication 10, **caractérisée en ce que** le capteur magnétique est un capteur à magnétorésistance géante qui est agencé pour envoyer un signal électrique à une unité électronique de commande (60) qui est agencée pour commander la mise en marche d'un générateur électronique de son (62) ou de vibrations dès que la résistance électrique du capteur varie sous l'effet du déplacement d'un aimant (88) qui commence à se mouvoir lorsque le dispositif mécanique (20) d'exécution de la première fonction mécanique se met en marche.

14. Montre-bracelet selon la revendication 10, **caractérisée en ce que** le capteur inductif (90) comprend un bobinage (92) réalisé autour d'un circuit magnétique (94) et est agencé pour envoyer un signal électrique à une unité électronique de commande (60) qui est agencée pour commander la mise en marche d'un générateur électronique de son (62) ou de vibrations dès qu'un courant électrique est induit dans le bobinage (92) sous l'effet du déplacement d'un aimant (88) qui commence à se mouvoir lorsque le dispositif mécanique (20) d'exécution de la première fonction mécanique se met en marche.

15. Montre-bracelet selon la revendication 10, **caractérisée en ce que** le capteur inductif (90) comprend un circuit oscillant LC agencé pour envoyer un signal électrique à une unité électronique de commande (60) qui est agencée pour commander la mise en marche d'un générateur électronique de son (62) ou de vibrations dès que l'inductance varie sous l'effet d'un déplacement d'un mobile métallique du dispositif mécanique (20).

16. Montre-bracelet selon l'une quelconque des revendications 1 ou 2, **caractérisée en ce que** le dispositif électronique (56) d'exécution de la seconde fonction électronique comprend un microphone (96) agencé pour détecter l'onde acoustique produite par la mise en marche du dispositif mécanique (20) d'exécution de la première fonction mécanique et pour envoyer un signal électrique à une unité électronique de commande (60) qui commande la mise en marche d'un générateur électronique de son (62) ou de vibrations.

17. Montre-bracelet selon l'une quelconque des revendications 1 ou 2, **caractérisée en ce que** le dispositif électronique (56) d'exécution de la seconde fonction électronique comprend un accéléromètre agencé pour détecter les vibrations mécaniques engendrées par la mise en marche du dispositif mécanique (20) d'exécution de la première fonction mécanique et pour envoyer un signal électrique à une unité électronique de commande (60) qui commande la mise en marche d'un générateur électronique de son (62) ou de vibrations.

18. Montre-bracelet selon l'une quelconque des revendications 1 ou 2, **caractérisée en ce que** le dispositif mécanique (20) d'exécution de la première fonction mécanique comprend un organe indicateur mécanique (98) qui fournit une indication sur l'état armé ou non-armé du dispositif mécanique (20) d'exécution de la première fonction mécanique, et le dispositif électronique (56) comprend des moyens agencés pour scruter l'indication fournie par l'organe indicateur mécanique (98) et des moyens qui sont agencés pour détecter l'instant auquel la première fonction mécanique va se déclencher.

19. Montre-bracelet selon la revendication 18, **caractérisée en ce que** l'organe indicateur mécanique (98) comprend une pastille (100) dont une première portion de surface (100a) est absorbante et dont une seconde portion de surface (100b) est réfléchissante, cette pastille (100) étant agencée pour se déplacer entre une première et une seconde position selon que le dispositif mécanique (20) est non-armé ou armé, et **en ce que** le dispositif électronique (56) comprend une source de lumière (102) et un capteur de lumière (104) logés dans le bracelet (4), sous la pastille (100), la lumière émise par la source de lumière (102) étant donc absorbée ou réfléchie selon qu'elle tombe sur la première portion de surface (100a) absorbante ou sur la seconde portion de surface (100b) réfléchissante de la pastille (100), un capteur d'images (106) capable de détecter la mise en mouvement d'un mobile du dispositif mécanique (20) commençant à scruter le moment où le dispositif mécanique (20) va se mettre en marche lorsque le capteur de lumière (104) capte la lumière réfléchie par la seconde portion de surface (100b) réfléchissante de la pastille (100).

20. Montre-bracelet selon la revendication 18, **caractérisée en ce que** le dispositif électronique (56) comprend une source de lumière (102) et un capteur de lumière (104) logés dans le bracelet (4), sous une pastille dont une première portion de surface réfléchit la lumière selon une direction dans laquelle le capteur de lumière (104) ne peut capter la lumière et dont une seconde portion de surface réfléchit la lumière en direction du capteur de lumière (104), cette pastille (100) étant agencée pour se déplacer entre une première et une seconde position selon que le dispositif mécanique (20) est non-armé ou armé, la lumière émise par la source de lumière (102) étant donc déviée ou réfléchie selon qu'elle tombe sur la première portion de surface ou sur la seconde portion de surface de la pastille, un capteur d'images (106) capable de détecter la mise en mouvement d'un mobile du dispositif mécanique (20) commençant à scruter le moment où le dispositif mécanique (20) va se mettre en marche lorsque le capteur de lumière (104) capte la lumière réfléchie par la pastille.

21. Montre-bracelet selon la revendication 18, **caractérisée en ce que** le dispositif mécanique de sonnerie comprend un capteur d'images (110) dont une première fraction de la surface (110a) est utilisée pour scruter l'indication fournie par l'organe indicateur mécanique (98), et dont une seconde fraction de la surface (110b) est utilisée pour scruter la mise en marche du dispositif mécanique de sonnerie (20).

22. Procédé de génération d'un signal d'alarme acoustique dans une montre-bracelet comprenant une boîte de montre (2) dans laquelle est logé un mouvement d'horlogerie mécanique (18) comprenant un dispositif mécanique (20) de sonnerie agencé pour produire un premier signal d'alarme acoustique, la boîte de montre (2) étant associée à un bracelet (4) dans lequel est logé un dispositif électronique (56) pour produire un second signal d'alarme acoustique et/ou une vibration mécanique, le dispositif électronique (56) étant agencé pour produire le second signal d'alarme acoustique au moment où le dispositif mécanique (20) d'exécution de la première fonction mécanique produit le premier signal d'alarme acoustique ou après une durée préétablie ou sélectionnable par l'utilisateur suivant la mise en marche du dispositif mécanique (20).
